# EUROPEAN PATENT APPLICATION

(11) **EP 2 099 128 A1**
(43) Date of publication of application: **09.09.2009**
(21) Application number: 09380036.5
(22) Date of filing: 27.02.2009
(51) Int. Cl.: H03G 3/30

(54) **Power control system in transmitters**

(30) Priority: 03.03.2008 ES 200800618
(71) Applicant: Fundación Cetena, 31110 Noain (Navarra) (ES)
(72) Inventor: Bravo Menendez-Rivas, Rodrigo, 31110 Noain ( Navarra) (ES); Alonso Marrodan, Sergio, 31110 Noain ( Navarra) (ES)
(74) Representative: Ungria Lopez, Javier

(57) **Abstract**

Self-regulation power system in transmitters for the ISM band, being of utility for its incorporation in the RF (radio frequency) transceiver module for transmitting and receiving wireless signals for digital communications in the European ISM (Industrial Scientific Medical) license free band 868-870 MHz, the system being based on the incorporation into a transceiver module (5) of a power detector (6) associated with an amplifier (7) with voltage-controllable gain, said power detector (6) being provided at the output from the amplifier (7) with voltage-controllable gain and said power detector (6) communicating the output voltage, which is dependent on the power of the amplifier, to a microcontroller (8) which, according to the output power required by the amplifier (7), sends the amplifier (7) the appropriate control voltage.

## Description

### OBJECT OF THE INVENTION

As stated in the title of this descriptive specification, the following invention relates to a self-regulation power system in transmitters for the ISM band, being of utility for its incorporation in the RF (radio frequency) transceiver module for transmitting and receiving wireless signals for digital communications in the European ISM (Industrial Scientific Medical) license free band 868-870 MHz, having the aim of dynamically adjusting the output power of an amplifier with voltage-controllable gain by means of a control voltage for it.

Moreover, the system itself is capable of self-regulation and transmitting the power appropriate for each specific application, due to being fitted with a sensor or detector for the transmitted power which, when used in conjunction with the gain control, permits said self-regulation, in a way that is precise and robust.

Likewise, being able to adjust the transmission power to the minimum necessary leads to a saving in energy, a better exploitation is achieved of the radioelectric spectrum and in general a product is had that is more versatile and adaptable to each specific scenario.

### FIELD OF APPLICATION

This specification describes a self-regulation power system in transmitters for the ISM band, which is conceived in the context of a generic RF (radio frequency) transceiver module, provided with an amplifier with voltage-controllable gain, for transmitting and receiving wireless signals for digital communications in the European ISM (Industrial Scientific Medical) license free band 868-870 MHz.

More specifically, it makes reference to a 500 mW RF transceiver module, which permits the highest possible power to be transmitted (27 dBm, equivalent to 500 mW), according to the European Norm in the sub-band 869.4-869.65 MHz.

### BACKGROUND OF THE INVENTION

As is known, for digital communications there exists a European ISM (Industrial Scientific Medical) license free band 868-870 MHz, which permits wireless signals to be transmitted and received, for which a RF (radio frequency) transceiver module is used, being able to make reference more specifically to RF transceiver modules of 500 mW, which permit a higher power to be transmitted, such that said power can reach up to 27 dBm (equivalent to 500 mW). This maximum value is the limit which the European Norm sets in the sub-band 869.4-869.65 MHz.

The possibility of emitting a higher power endows the transmitter with a greater radioelectric range, such that said power is achieved by adding a power amplifier to the RF transceiver module.

In this way, a first option is to fix the gain of the amplifier so that 27 dBm is obtained at the outlet constantly (aside from tolerances and possible drifts with temperature and/or aging). So, conventionally, the transceiver modules usually have an output power fixed at 27 dBm, or slightly less in order not to infringe the European Norm.

However, this fact implies different drawbacks such as might be a greater energy expense and the generation of interferences due to zones beyond the required range being uselessly invaded.

Moreover, the said RF transceiver modules of the European ISM band also usually have a transmission power that can be adjusted by discrete steps.

### DESCRIPTION OF THE INVENTION

The present specification describes a self-regulation power system in transmitters for the ISM band, being of utility for its incorporation in the RF (radio frequency) transceiver module for transmitting and receiving wireless signals for digital communications in the European ISM (Industrial Scientific Medical) license free band 868-870 MHz, in such a way that the system is based on the combined use of the transceiver module, an amplifier with voltage-controllable gain and a power detector provided at the output of said amplifier, such that said power detector communicates an output voltage, which is dependent on the power of the amplifier, to a microcontroller and this, according to the output power required and the measurement made by the detector, sends the amplifier the appropriate correction to the control voltage.

So, in accordance with the output voltage from the detector, the microcontroller decides on the control voltage to send to the amplifier according to the output power required by the amplifier, thus carrying out self-regulation.

The control voltage sent by the microcontroller to the amplifier will increase or reduce the gain of the amplifier if the output power from the amplifier is less or greater, respectively, than that required.

In order to complement the description that is going to be made forthwith, and with the aim of facilitating a better understanding of the characteristics of the invention, this specification is accompanied by a set of plans containing figures in which, on an illustrative rather than limiting basis, the most characteristic details of the invention have been represented.

### BRIEF DESCRIPTION OF THE DESIGNS

Figure 1. Shows a basic block diagram of a conventional type 500 mW RF transceiver module.
Figure 2. Shows the graph of a typical curve of the variation in power as a function of the control voltage, according to temperature.
Figure 3. Shows a block diagram of a 500 mW RF transceiver module with the incorporation of a control loop, based on the combination of an amplifier with voltage-controllable gain and a power detector, in accordance with the invention.
Figure 4. Shows the graph of a typical curve of the voltage of the power detector as a function of the transmitted power, according to temperature.

### DESCRIPTION OF A PREFERRED EMBODIMENT

With the said figures in view and in accordance with the adopted numbering, we can see how the conventional type 500 mW RF transceiver module 1 incorporates an amplifier 2 with a transmission power output that is either fixed or adjustable in discrete steps (for example, 21 dBm, 23 dBm, 25 dBm, 27 dBm, etc.).

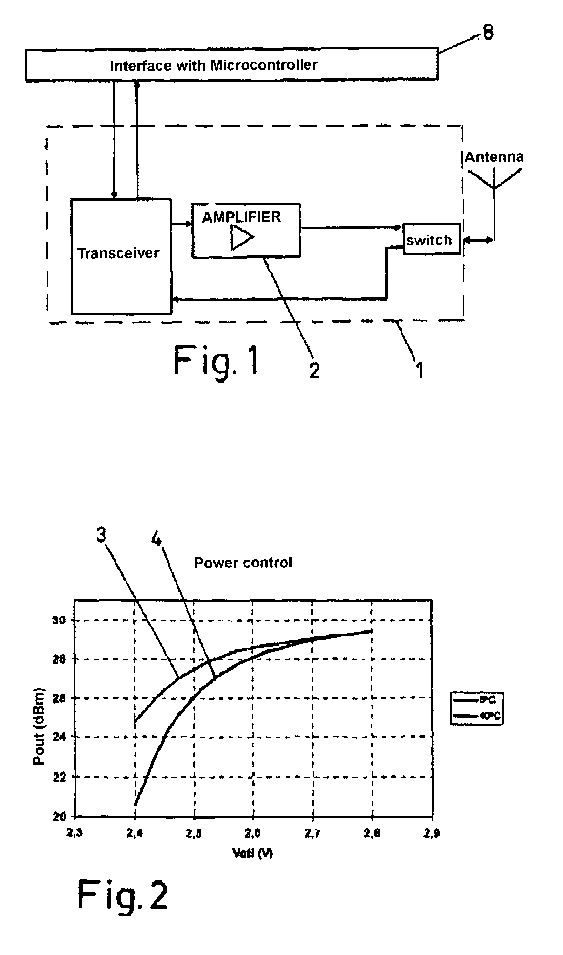

Figure 2 of the designs represents the graph of a typical curve of the variation in power as a function of the control voltage, according to temperature, the curve 3 being for a temperature of 40° C and the curve 4 for a temperature of 5° C.

With the aim of being able to dynamically adjust the output power of the amplifier of an RF transceiver module, and more specifically a 500 mW RF transceiver module, the present invention describes a system that is based on the incorporation into the transceiver module 5 of a power detector 6 at the output from the amplifier 7 with voltage-controllable gain in such a way that said power detector 6 communicates the output voltage, dependent on the output power of the amplifier, to a microcontroller 8.

So, according to the voltage sent by the power detector 6 and depending on the output power required by the amplifier 7, the microcontroller 8 decides on the control voltage that it sends to the amplifier.

In other words, according to the output voltage of the amplifier 7 with voltage-controllable gain, the microcontroller decides on the control voltage to send to the amplifier 7 according to the output power required by the amplifier, or putting this another way, the system itself is self-regulating.

So, the control voltage sent by the microcontroller 8 to the amplifier 7 will increase or reduce the gain of the amplifier 7 if the output power from the amplifier is less or greater, respectively, than that required.

In this way, the output power is able to be dynamically adjusted by means of the control voltage, having a continuous interval of transmission power.

In principle, this degree of additional flexibility has the counterpart of exhibiting a certain dependence of the gain/voltage curve with temperature, which adds an uncertainty in terms of the real value of the transmitted power. This uncertainty (of the order of ± 2 dB, as can be seen in Fig. 2) is added to the actual tolerance of the transceiver in terms of the transmitted power, which is typically of the order of ± 1.5 dB, having a total uncertainty of ± 3.5 dB.

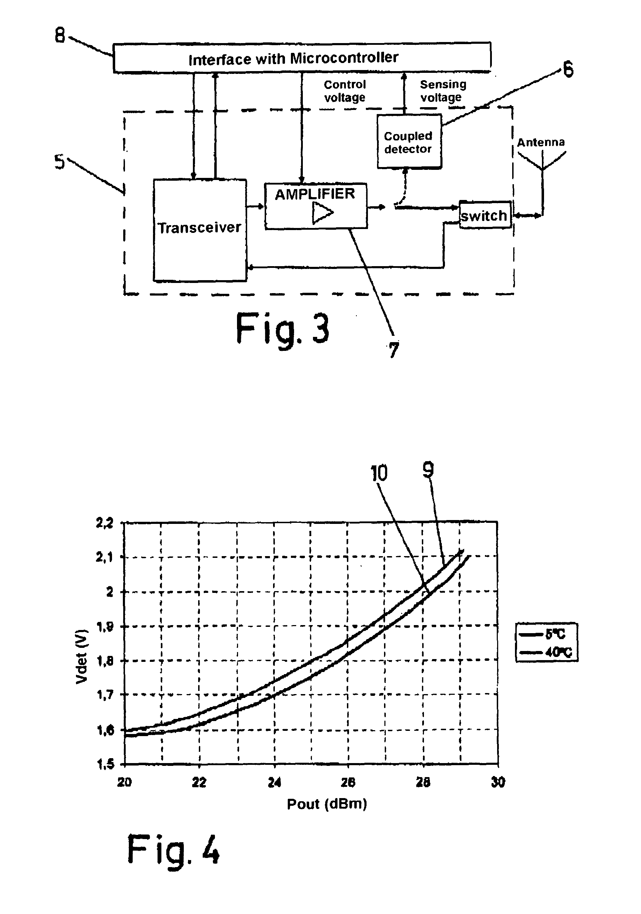

Moreover, the power detector 6 is practically immune to the variation in temperature, allowing measurements of power to be obtained with an extremely high reliability. In this way, figure 4 of the designs shows a graph of a typical curve of the voltage of the power detector as a function of the transmitted power, according to temperature, where it can be seen that its variation is minimal. So, curve 9 is for a temperature of 40° C and curve 10 is for a temperature of 5° C, with the dispersion between the two being less than ± 0.5 dB.

Indeed, the fact of having an RF transceiver module of adjustable power with self-regulation power presents the following advantages:
- Flexibility: a continuous interval of transmission power is had, which means that this power can be adapted to the needs of the specific application.
- Robustness: due to having a control loop, the power can be measured continuously and be corrected in order to keep it within its proper value, in the event of the transceiver + amplifier assembly undergoing deviations with time and with ambient conditions.
- Precision: a typical uncertainty of ± 0.5 dB is achieved compared to ± 3.5 dB if regulation is not used.
- Energy saving in the transmitter node: the power is adjusted to the minimum necessary.
- Minimization of interferences on other systems, since the range is adjusted to the required interval, in other words, there is no need to invade zones beyond the desired range.
- Desensitization towards variations with temperature and tolerance: the self-sensing permits the power that is transmitted to be known precisely and to proceed to correct it in the event of deviation due to tolerances of components or drift with temperature or other factors.

## Claims

1. SELF-REGULATION POWER SYSTEM IN TRANSMITTERS FOR THE ISM BAND, being of utility for its incorporation in the RF (radio frequency) transceiver module for transmitting and receiving wireless signals for digital communications in the European ISM (Industrial Scientific Medical) license free band 868-870 MHz, **characterized in that** the system is based on the incorporation into a transceiver module (5) of a power detector (6) associated with an amplifier (7) with voltage-controllable gain, said power detector (6) being provided at the output from the amplifier (7) with voltage-controllable gain and said power detector (6) communicating the output voltage, which is dependent on the power of the amplifier, to a microcontroller (8) which, according to the output power required by the amplifier (7), sends the amplifier (7) the appropriate control voltage.

2. SELF-REGULATION POWER SYSTEM IN TRANSMITTERS FOR THE ISM BAND, according to claim 1, **characterized in that,** according to the output voltage of the amplifier (7) with voltage-controllable gain, the microcontroller (8) decides on the control voltage to send to the amplifier (7) depending on the output power required by the amplifier (7), thus carrying out self-regulation.

3. SELF-REGULATION POWER SYSTEM IN TRANSMITTERS FOR THE ISM BAND, according to claims 1 and 2, **characterized in that** the control voltage sent by the microcontroller (8) to the amplifier will increase or reduce the gain of the amplifier (7) if the output power from the amplifier (7) with voltage-controllable gain is less or greater, respectively, than that required.
